# EUROPEAN PATENT SPECIFICATION

(11) **EP 3 806 142 B1**
(45) Date of publication and mention of the grant of the patent: **21.05.2025**
(21) Application number: 19201817.4
(22) Date of filing: 08.10.2019
(51) Int. Cl.: H01L 23/26, H01L 23/053, H01L 23/31, H01L 25/07, H01L 23/049, H01L 23/00

(54) **SEMICONDUCTOR MODULE AND METHOD FOR PRODUCING THE SAME**
HALBLEITERMODUL UND VERFAHREN ZU SEINER HERSTELLUNG
MODULE SEMICONDUCTEUR ET SON PROCÉDÉ DE PRODUCTION

(43) Date of publication of application: 14.04.2021
(73) Proprietor: Infineon Technologies AG, 85579 Neubiberg (DE)
(72) Inventor: UHLIG, Johannes, 59494 Soest (DE)
(74) Representative: Westphal, Mussgnug & Partner, Patentanwälte mbB

(56) References cited:
- DE-A1- 102008 054 932
- DE-A1- 102016 101 694
- US-A1- 2003 087 448
- US-A1- 2017 012 030

## Description

### TECHNICAL FIELD

The instant disclosure relates to a semiconductor module and a method for producing the same.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted onto the semiconductor substrate by soldering or sintering techniques.

Electrical lines or electrical connections are used to connect different semiconductor devices. Such electrical lines and electrical connections may include metal and/or semiconductor material. The housings of power semiconductor module arrangements are generally permeable to gases to a certain extent. Some gases such as sulfur containing gases, for example, may react with metallic components inside the housing. This leads to a chemical degradation of these components which may result in a failure of individual components and ultimately of the whole semiconductor arrangement.

Document DE 10 2016 101694 A1 discloses an electronic module having a module housing and a protective mass located in the module housing. The protective compound has a matrix and a reaction partner which is distributed in the matrix and which is designed to form a chemical pollutant consisting of sulfur or a sulfur which is introduced into an interior space of the module housing penetrates to chemically react and thereby prevent the sulfur from causing corrosion of a component of the electronic module to be protected.

Document US 2003/087448 A1 discloses an airtight configuration for keeping down the permeation of corrosive gas from silicone adhesive, and for preventing corrosive gas from entering the case. An electronic device mounted on vehicle, the electronic device has at least one of a portion connecting components, and a portion sealing the clearance or hole where exists in the electronic device. The at least one of the connection portion and the seal portion is constituted by using adhesive or sealant which has at least one of a function adsorbing corrosive gas and a function trapping corrosive gas with chemical reaction.

Document DE 10 2008 054932 A1 discloses a power semiconductor module with a base plate which is designed as a ceramic substrate metallized at least on the inside of the module and which has a mounting surface facing the interior of the module, on which a power semiconductor circuit with at least one power semiconductor chip is arranged; at least one stiffening rib serving to stiffen the base plate, which projects beyond the mounting surface, and which is fixedly connected to the base plate or formed integrally therewith.

There is a need for a semiconductor module arrangement that offers protection for the semiconductor components arranged therein against corrosion such that the overall lifetime of the power semiconductor module arrangement is increased.

### SUMMARY

In accordance with the present invention, there is provided a first power semiconductor module according to claim 1.

In accordance with the present invention, there is provided a second power semiconductor module according to claim 9.

Also in accordance with the present invention, there is provided a first method for producing a power semiconductor module according to claim 11.

Also in accordance with the present invention, there is provided a second method for producing a power semiconductor module according to claim 12.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement, not forming part of the present invention but useful for understanding it.
Figure 2 is a cross-sectional view of another power semiconductor module arrangement, not forming part of the present invention but useful for understanding it.
Figure 3 is a cross-sectional view of a power semiconductor module arrangement according to one example, not forming part of the present invention but useful for understanding it.
Figure 4 is a cross-sectional view of a power semiconductor module arrangement according to the present invention.
Figure 5 is a cross-sectional view of a power semiconductor module arrangement according to another example, not forming part of the present invention but useful for understanding it.
Figure 6 is a cross-sectional view of a power semiconductor module arrangement according to the present invention.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

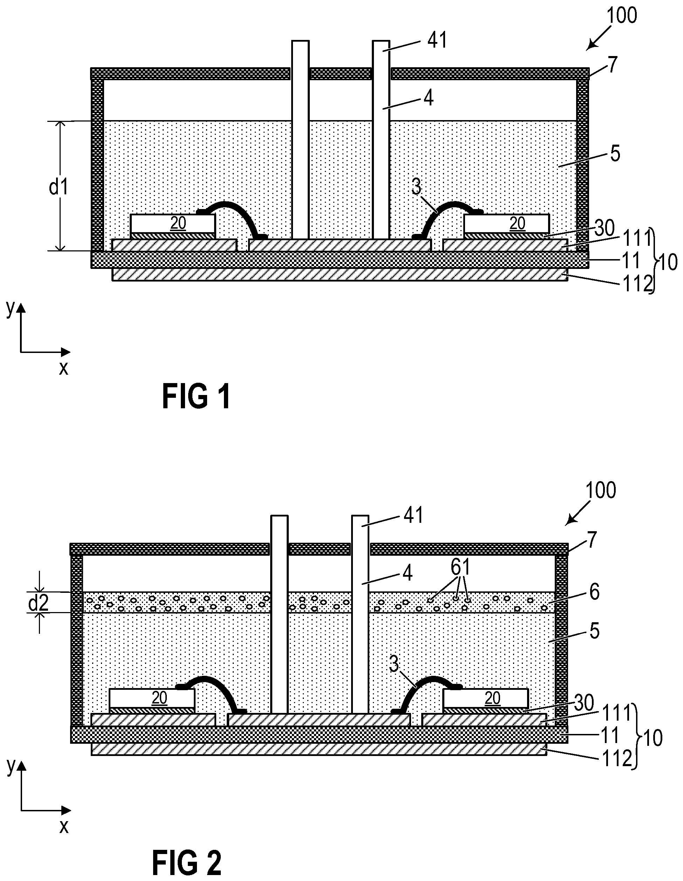

Referring to Figure 1, a cross-sectional view of a power semiconductor module arrangement 100 is illustrated. The power semiconductor module arrangement 100 includes a housing 7 and a semiconductor substrate 10 (dielectric substrate). The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminium Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

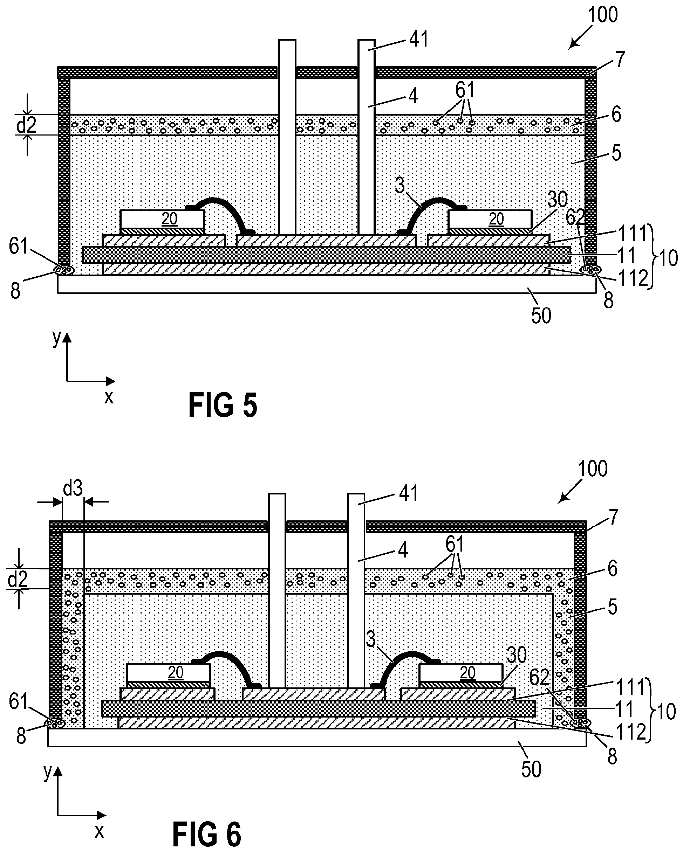

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 is arranged inside the housing 7. According to another example, the semiconductor substrate 10 may be mounted on a base plate (see, e.g., Figures 5 and 6). In some power semiconductor module arrangements 100, more than one semiconductor substrate 10 is arranged on a single base plate. A base plate may form a ground surface of the housing 7, for example.

One or more semiconductor bodies 20 may be arranged on the at least one semiconductor substrate 10. Each of the semiconductor bodies 20 arranged on the at least one semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" in this context means that the first metallization layer 111 is not a continuous layer, but includes recesses between different sections of the layer. Such recesses are schematically illustrated in Figure 1. The first metallization layer 111 in this example includes three different sections. Different semiconductor bodies 20 may be mounted on the same or to different sections of the first metallization layer 111. Different sections of the first metallization layer may have no electrical connection or may be electrically connected to one or more other sections using, e.g., bonding wires 3. Electrical connections 3 may also include bonding ribbons, connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contact from outside the housing 7 in any other suitable way. For example, terminal elements 4 may be arranged closer or adjacent to the sidewalls of the housing 7. It is also possible that terminal elements 4 protrude vertically or horizontally through the sidewalls of the housing 7. It is even possible that terminal elements 4 protrude through a ground surface of the housing 7.

The semiconductor bodies 20 each may include a chip pad metallization, e.g., a source, drain, anode, cathode or gate metallization. A chip pad metallization generally provides a contact surface for electrically connecting the semiconductor body 20. The chip pad metallization may electrically contact a connection layer 30, a terminal element 4, or an electrical connection 3, for example. A chip pad metallization may consist of or include a metal such as aluminum, copper, gold or silver, for example. The electrical connections 3 and the terminal elements 4 may also consist of or include a metal such as copper, aluminum, gold, or silver, for example.

The above mentioned components, as well as other components of the semiconductor arrangement inside the housing 7, may corrode when they come into contact with corrosive gases. Corrosive gases may include, e.g., sulfur or sulfur-containing compounds. Corrosive gases in the surrounding area of the power semiconductor module arrangement 100 may penetrate into the inside of the housing 7. The housings 7 that are used for power semiconductor module arrangements 100 are usually not fully protected against protruding gases. Further, corrosive gases may enter the housing 7 when the housing 7 is opened or during production before the housing 7 is closed, for example. Inside the housing 7, the corrosive gases may form acids or solutions, for example, in combination with moisture that is present inside the housing 7. The corrosive gases or the resulting solutions may cause a corrosion of some or all of the components. During the corrosion process, the metallic constituents of the components may be oxidized to their respective sulfides. The sulfide formation may alter the electrical properties of the components or may result in the formation of new conductive connections and in short circuits within the power semiconductor module arrangement 100.

Examples for corrosive gases are hydrogen sulfide (H₂S), carbonyl sulfide (OCS), or gaseous sulfur (S₈). Generally, it is also possible that sulfur gets to the inside of the housing 7 as constituent of a solid material or liquid.

Components including one or more metals such as copper (e.g., first metallization layer 111, electrical connection 3, terminal element 4, connection layer 30, chip pad metallization), silver (e.g., first metallization layer 111, electrical connection 3, terminal element 4, connection layer 30, chip pad metallization), or lead (e.g. connection layer 30 including leaded solder), may be particularly sensitive to corrosion. Other metals such as aluminum, for example, may have a thin oxide layer covering their surface area, which may provide at least a certain amount of protection against corrosive gases.

The power semiconductor module arrangement 100 generally further includes a casting compound 5. The casting compound 5 may consist of or include a silicone gel, a silicone, polyurethane, epoxy, or polyacrylate based isolation material, or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 41, however, are not covered by the casting compound 5 and protrude from the casting compound 5 through the housing 7 to the outside of the housing 7. The casting compound 5 is configured to protect the components and electrical connections inside the power semiconductor module 100, in particular inside the housing 7, from certain environmental conditions and mechanical damage. However, corrosive gases are usually able to penetrate through the casting compound 5. The casting compound 5, therefore, is usually not able to protect the components and electrical connections from corrosive gases.

The casting compound 5 may form a first protective layer with a first thickness d1 in a vertical direction y. The vertical direction y is a direction that is essentially perpendicular to a top surface of the semiconductor substrate 10. The top surface of the semiconductor substrate 10 is a surface on which semiconductor bodies 20 are or may be mounted. The first protective layer 5 at least partly covers any components that are arranged on the top surface of the semiconductor substrate 10 as well as any exposed surfaces of the semiconductor substrate 10. The first thickness d1 may be between 1mm and 10mm, for example.

Referring to Figure 2, to additionally protect the components inside the housing 7 against corrosive gases, the power semiconductor module arrangement 100 further includes a second protective layer 6. The second protective layer 6 is arranged on a top surface of the first protective layer 5. The top surface of the first protective layer 5 is a surface opposite to its lower surface, wherein the lower surface covers the components and the semiconductor substrate 10. The second protective layer 6 is configured to seal at least a part of the inside of the housing 7. For example, the inside of the housing 7 may be divided into two areas, namely a first area in which the semiconductor substrate 10 and any components and electrical connections mounted on the semiconductor substrate 10 are arranged, and a second area which does not include any major components. For example, the first protective layer 5 may form an essential part of the first area. The terminal elements 4 may pass from the semiconductor substrate 10 through the first area (first protective layer 5) and through the second area to the outside of the housing 7. Without a second protective layer 6, corrosive gases may, for example, penetrate the second area and then reach the components of the semiconductor arrangement through the first area. The second protective layer 6 is arranged between the first area and the second area, thereby protecting the first area and any components arranged in the first area against the corrosive gases. Corrosive gases, for example, may enter the second area of the inside of the housing 7 through the openings that allow the terminal elements 4 to pass through the housing 7. The corrosive gases, however, are prevented from entering the first area by the second protective layer 6.

The second protective layer 6 may have a second thickness d2 in the vertical direction y. The second thickness d2 may be between 0.3mm and 10mm, for example. The second protective layer 6 includes a first material. The first material may be a dielectric material. The second protective layer 6 further includes a reactant 61. The reactant 61 is configured to chemically react with the corrosive gases, or, in particular, with the sulfur or sulfur-containing compounds of the corrosive gases. If the reactant 61 itself is electrically conductive, the concentration of the reactant 61 in the first material may be chosen such that the second protective layer 6 as a whole is still dielectrically insulating. Corrosive gas may also be trapped, adsorbed or absorbed by the reactant 61. By chemically reacting with the corrosive gas, the reactant 61 prevents the harmful substances from reaching the (metal) components inside the housing 7 and thereby protects the components against corrosion. The reactant 61 may be, for example, a powder of a second material which is (evenly) distributed throughout the first material of the second protective layer 6. The second material may include a metallic material such as, e.g., Ag, Fe, Co, Ni, Cu, Sn, Pb, Mn or may include activated carbon, for example. These are, however, only examples. Any additional or alternative materials which react with the corrosive gases and which may, e.g., form a metal sulfide when exposed to corrosive gases, are also possible. The reactant 61 may be essentially evenly distributed throughout the second protective layer 6. The first material may consist of or include a non-reactive polymer such as a silicone gel, acrylate, polyurethane, or silicone rubber, for example. Other casting materials are also possible such as epoxy resin, for example.

If the second material is an electrically conductive material such as a metallic material, for example, the concentration of the second material in the second protective layer 6 may be such that the second protective layer 6 as a whole is still electrically insulating.

In Figures 1 and 2, semiconductor module arrangements without base plate are schematically illustrated. In such semiconductor module arrangements, the semiconductor substrate 10 may form a bottom of the housing 7. The housing 7 itself may only comprise sidewalls and a cover, for example. The sidewalls of the housing 7 may be attached to the semiconductor substrate 10 in any suitable way. For example, the sidewalls may be glued, brazed or soldered to the semiconductor substrate 10. Some semiconductor module arrangements are known wherein a fluoropolymer is arranged between the semiconductor substrate 10 and the sidewalls of the housing 7. That is, there is some kind of seal arranged between the semiconductor substrate 10 and the housing 7 which is configured to attach the housing 7 to the semiconductor substrate 10 and further to prevent gasses from entering the housing 7.

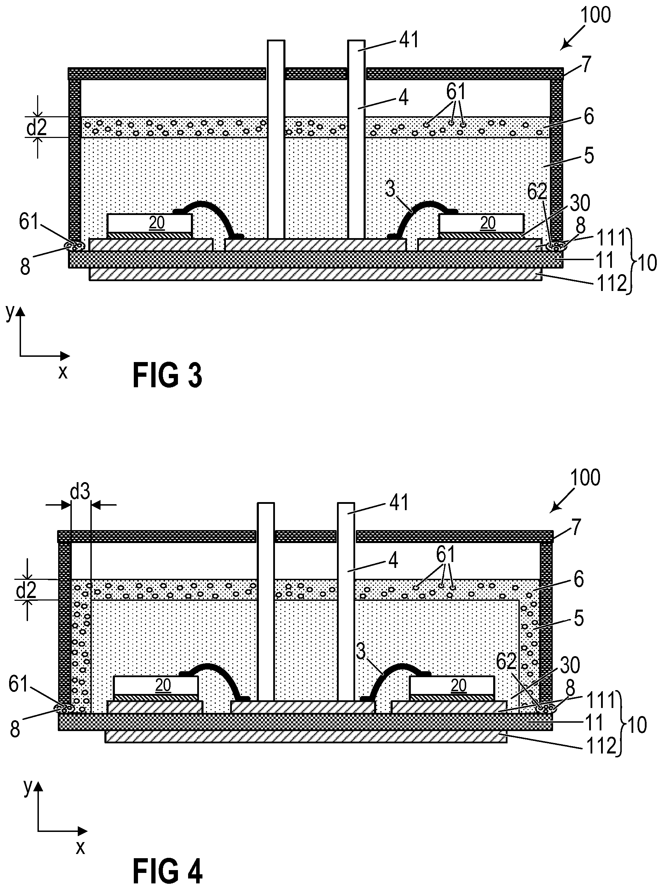

Referring to Figure 3, a semiconductor module arrangement 100 comprising a seal 8 between the semiconductor substrate 10 and the housing 7 is schematically illustrated. According to one example, the seal comprises a third material. The third material may consist of or include a non-reactive polymer such as a silicone gel, acrylate, polyurethane, or silicone rubber, for example. Other casting materials are also possible such as epoxy resin, for example. The seal 8 may further comprise a fourth material 62 which may include a metallic material such as, e.g., Ag, Fe, Co, Ni, Cu, Sn, Pb, Mn or may include activated carbon, for example. The fourth material 62 generally has the same function as the second material 61 that has been described with respect to the second protective layer 6 above. That is, the fourth material 62 includes a reactant that is configured to chemically react with corrosive gases, or, in particular, with sulfur or sulfur-containing compounds of corrosive gases. Corrosive gas may also be trapped, adsorbed or absorbed by the reactant. By chemically reacting with the corrosive gas, the reactant prevents the harmful substances from reaching the (metal) components inside the housing 7 and thereby protects the components against corrosion. The reactant may be, for example, a powder of the fourth material 62 which is (evenly) distributed throughout the third material of the seal 8.

The second protective layer 6 in the example illustrated in Figure 3 is arranged on top of the first protective layer 5. That is, the first protective layer 5 is arranged between the second protective layer 6 and the semiconductor substrate 10. The second protective layer 6, therefore, cannot prevent gasses, e.g., corrosive gasses, entering the housing through the joint between the semiconductor substrate 10 and the housing 7 from reaching the elements mounted on the semiconductor substrate 10. Any gasses entering the housing 7 in this way only need to penetrate the first protective layer 5. The additional seal 8 comprising the third material and the fourth material 62, therefore, provides a further barrier for corrosive gasses. The semiconductor module arrangement 100, therefore, is better protected against corrosive gasses than semiconductor module arrangements not comprising the seal 8.

In the example illustrated in Figure 3, the second protective layer 6 only covers the first protective layer 5 in the vertical direction y. This, however, is only an example. Now referring to Figure 4, in accordance with the present invention, second protective layer 6, in addition to a top surface of the first protective layer 5, further extends along the side surfaces of the first protective layer 5. The top surface of the first protective layer 5 is a surface facing away from the semiconductor substrate 10. The side surfaces of the first protective layer 5 are surfaces perpendicular to the top surface and facing the sidewalls of the housing 7. That is, the second protective layer 6 is arranged between the first protective layer 5 and the sidewalls of the housing 7. The second protective layer 6 may extend along the side surfaces of the first protective layer 5 all the way down towards the semiconductor substrate 10. That is, the second protective layer 6 is also arranged between the elements arranged on the semiconductor substrate 10 and the joint between the semiconductor substrate 10 and the housing 7. In this way, the second protective layer 6 also prevents corrosive gases entering through the joint from reaching the components arranged on the semiconductor substrate 10. The barrier for corrosive gasses, therefore, is even increased as compared to the arrangement of Figure 3.

The second protective layer 6 has a horizontal section covering the first protective layer 5 in the vertical direction y, and vertical sections which cover the side surfaces of the first protective layer 5. The horizontal section may have a second thickness d2 in the vertical direction y, as has already been described above. The second thickness d2 may be between 0.3mm and 10mm, for example. The vertical sections may each have a third thickness d3 in the horizontal direction x. The third thickness d3 may be between 0.3mm and 10mm, for example. The third thickness d3 may equal the second thickness d2, for example.

Ideally, there are no gaps or spaces between the second protective layer 6 and the sidewalls of the housing 7, between the second protective layer 6 and the semiconductor substrate 10 (Figure 4), as well as between the second protective layer 6 and any other components (e.g., terminal elements 4) which extend through the second protective layer 6.

As the reactant 61 of the second protective layer 6 may include a metal, for example, the first protective layer 5 that is arranged between the second protective layer 6 and the components arranged on the semiconductor substrate 10 prevents the reactant from reacting with the metal including components mounted on the semiconductor substrate 10.

In the examples illustrated in Figures 3 and 4, the semiconductor module arrangement does not comprise a base plate and the housing 7 does not comprise a bottom. This, however, is only one embodiment of the present invention. Figure 5 schematically illustrates a semiconductor arrangement similar to the arrangement of Figure 3, the only difference being that the semiconductor arrangement 100 of Figure 5 comprises a bottom or a base plate 50. That is, the housing 7 is not attached to the semiconductor substrate 10 but to the bottom or base plate 50 instead. The semiconductor substrate 10 is arranged on the bottom or base plate 50 and inside the housing 7. All that has been described with respect to Figure 3 above also simultaneously applies for the arrangement of Figure 5. The second protective layer 6 of the arrangement in Figure 5 corresponds to the second protective layer 6 of the arrangement of Figure 3, the first protective layer 5 of the arrangement in Figure 5 corresponds to the first protective layer 5 of the arrangement of Figure 3, and so on. The seal 8 that is arranged between the housing 7 and the bottom or base plate 50 in the arrangement of Figure 5 corresponds to the seal 8 that has been described with respect to Figure 3 above.

The same applies for the arrangement that is schematically illustrated in Figure 6 and the arrangement that has been described with respect to Figure 4 above. According to the present invention, the arrangement of Figure 6 comprises a bottom or base plate 50 which is not present in the arrangement of Figure 4. Otherwise the arrangements of Figures 4 and 6 correspond to each other.

According to one example, the second protective layer 6 may be produced as a flexible mat. The flexible mat may be produced separately and may then be placed on the top surface of the first protective layer 5. It is, however, generally also possible that the second protective layer 6 is produced as a rigid plate instead of a flexible mat. A second protective layer 6 may have a hardness that is not very sticking and, therefore, rather easy to handle. Another hardness, however, is also possible.

The second protective layer 6 may be produced by any suitable process such as casting or molding, for example. The materials forming the second protective layer 6, in particular the first material, may originally be in a liquid or viscous form. A mixture may be produced by mixing the first material and the second material. The mixture may then be filled into a casting mold, for example. After filling the mixture into the casting mold, the mixture may be developed (processed) into a solid or semi-solid mat or plate with the second material evenly distributed therein. The casting mold may have a simple rectangular or quadratic form, for example. The resulting mat or plate, therefore, may also have a rectangular or quadratic form. Recesses for the terminal elements may be cut out in a further step to adapt the form of the mat or plate to the geometry of the power semiconductor module arrangement 100. For example, an extrusion method may be used to shape the mat or plate. Extrusion methods are generally used to create objects of a fixed cross-sectional profile. A material (e.g., the solid or semi-solid mat or plate) is pushed through a die or press mold of the desired cross-section. In this way, very complex cross-sections of the mat or plate may be created. It is, however, also possible that the casting mold includes respective recesses such that the mat or plate is casted or molded in the desired shape without the need for a further cutting step.

The mat or plate may subsequently be removed from the casting mold. For example, the mat or plate may be produced by a supplier. The manufacturer of the power semiconductor module arrangement 100 may buy the finished mat or plate and may insert the mat or plate into a power semiconductor module arrangement during the mounting process. The manufacturer, however, does not need to perform a molding step and/or a curing or hardening process when assembling the power semiconductor module arrangement 100. By simply arranging the prefabricated mat or plate in the power semiconductor module arrangement 100, the mat or plate does not have a substance-to-substance bond with any of the other components of the power semiconductor module arrangement 100. In other words, it would be generally possible to remove the mat or plate from the power semiconductor module arrangement 100, without destroying any of the other components. For example, the mat or plate does not have a substance-to-substance bond with the sidewalls of the housing. The mat or plate may have a certain adhesive strength and may adhere to the sidewalls to a certain degree. However, this is not a permanent bond. The same applies to the bond between the mat or plate and the first protective layer 5.

Prefabricating the second protective layer 6, however, is only an example. It is also possible to first arrange the first protective layer 5 in the housing 7 and then fill the still liquid first material with the second material 62 distributed therein into the housing 7. The material in this case then needs to be hardened, e.g., by removing some or all of the liquid from the second protective layer 6. For example, a heating or drying step may be performed in order to remove the liquid.

With respect to the arrangements illustrated in Figures 3 and 5, the material of the first protective layer 5 may filled into the housing 7, followed by a hardening step (removing liquid from the first protective layer 5). The second protective layer 6 may then be easily formed on the top surface of the first protective layer 5.

With respect to the arrangements illustrated in Figures 4 and 6, a spacer may be inserted into the housing 7 before forming the first protective layer 5. The spacer may fill any spaces adjacent to the sidewalls of the housing 7 during formation of the first protective layer 5 which will later be needed for the second protective layer 6. Once the first protective layer 5 has been formed and hardened, the spacer may be removed. Afterwards, the materials of the second protective layer 6 is filled into the spaces between the first protective layer 5 and the sidewalls of the housing 7 and also on the top surface of the first protective layer 5.

The seal 8 is formed between the housing 7 and either the semiconductor substrate 10 or the bottom or base plate 50 before forming the first protective layer 5. For example, in a first step, at least the sidewalls of the housing 7 may be mounted onto the semiconductor substrate 10, bottom, or base plate 50. The seal 8 may be used to attach (glue, adhere) the sidewalls to the semiconductor substrate 10, bottom, or base plate 50. At this point, the housing 7 may be open in the vertical direction y. That is, either the lid of the housing 7 may not have been mounted on the sidewalls yet, or the lid may have an opening through which the materials of the first protective layer 5 and/or the second protective layer 6 may be filled into the housing 7 before hardening them. After forming the first protective layer 5 and the second protective layer 6 in the housing 7, the lid may be attached to the sidewalls to close the housing 7, or the opening in the lid may be sealed.

## Claims

1. A power semiconductor module arrangement (100) comprising:
a dielectric substrate (10), a housing (7) comprising sidewalls;
at least one semiconductor body (20) arranged on a top surface of the dielectric substrate (10);
a first protective layer (5) arranged on the top surface of the dielectric substrate (10), thereby covering the at least one semiconductor body (20);
a second protective layer (6) for protecting the power semiconductor module arrangement (100); and
a seal (8), wherein the second protective layer (6) comprises a first material and a second material (61),
wherein the second material (61) is distributed within the first material and
comprises a reactant, wherein the reactant is configured to chemically react with, trap, adsorb, or absorb corrosive gases;
the second protective layer (6) covers at least a top surface of the first protective layer (5), wherein a top surface of the first protective layer (5) is a surface facing away from the dielectric substrate (10),
the second protective layer (6) further comprises vertical sections covering side surfaces of the first protective layer (5) and arranged between the first protective layer (5) and the sidewalls of the housing (7), and
the seal (8) is arranged between the sidewalls of the housing (7) and the dielectric substrate (10), thereby attaching the housing (7) to the dielectric substrate (10), wherein the dielectric substrate forms a bottom of the housing, and the seal comprises a third material and a fourth material (62), wherein the fourth material (62) is distributed within the third material and comprises a reactant, wherein the reactant is configured to chemically react with, trap, adsorb, or absorb corrosive gases.

2. The power semiconductor module arrangement (100) of claim 1, wherein each of the first material and the third material comprises at least one of
a non-reactive polymer;
a casting materials; and
an epoxy resin.

3. The power semiconductor module arrangement (100) of claim 2, wherein the non-reactive polymer comprises silicone gel or silicone rubber.

4. The power semiconductor module arrangement (100) of any of claims 1 to 3, wherein each of the second material (61) and the fourth material (62) includes one of a metallic material and an activated carbon.

5. The power semiconductor module arrangement (100) of claim 4, wherein the metallic material comprises at least one of Ag, Fe, Co, Ni, Cu, Sn, Pb, and Mn.

6. The power semiconductor module arrangement (100) of any of the preceding claims, wherein the second protective layer (6) has a thickness in a vertical direction (y) of between 0.3mm and 10mm.

7. The power semiconductor module arrangement (100) of any of claims 1 to 6, wherein each of the vertical sections of the second protective layer (6) has a thickness in a horizontal direction (x) of between 0.3mm and 10mm.

8. The power semiconductor module arrangement (100) of any of the preceding claims,
wherein the inside of the housing (7) comprises a first area and a second area; and
wherein the second protective layer (6) is arranged between the first area and the second area in order to protect the at least one semiconductor body (20) from corrosive gases that are arranged in the first area.

9. A power semiconductor module arrangement (100) comprising:
a dielectric substrate (10) arranged within a housing (7), the housing (7) comprising sidewalls;
at least one semiconductor body (20) arranged on a top surface of the dielectric substrate (10);
a first protective layer (5) arranged on the top surface of the dielectric substrate (10), thereby covering the at least one semiconductor body (20);
a second protective layer (6) for protecting the power semiconductor module arrangement (100); and
a seal (8), wherein the second protective layer (6) comprises a first material and a second material (61),
wherein the second material (61) is distributed within the first material and
comprises a reactant, wherein the reactant is configured to chemically react with, trap, adsorb, or absorb corrosive gases;
the second protective layer (6) covers at least a top surface of the first protective layer (5), wherein a top surface of the first protective layer (5) is a surface facing away from the dielectric substrate (10),
the second protective layer (6) further comprises vertical sections covering side surfaces of the first protective layer (5) and arranged between the first protective layer (5) and the sidewalls of the housing (7), and
the seal (8) is arranged either between the sidewalls of the housing (7) and a bottom of the housing (7), or between the sidewalls of the housing (7) and a base plate (50), thereby attaching the housing (7) to the bottom of the housing or to the base plate (50), and the seal comprises a third material and a fourth material (62), wherein the fourth material (62) is distributed within the third material and comprises a reactant, wherein the reactant is configured to chemically react with, trap, adsorb, or absorb corrosive gases.

10. Method for producing a power semiconductor module arrangement (100), the method comprising:
arranging a seal (8) between sidewalls of a housing (7) and a dielectric substrate (10), thereby attaching the housing (7) to the dielectric substrate (10);
forming a first protective layer (5) on a top surface of the dielectric substrate (10), thereby covering at least one semiconductor body (20) arranged on the top surface of the dielectric substrate (10);
forming a second protective layer (6) on the first protective layer (5) for protecting the power semiconductor module arrangement (100), wherein
the second protective layer (6) comprises a first material and a second material (61), wherein the second material (61) is distributed within the first material and comprises a reactant, wherein the reactant is configured to chemically react with, trap, adsorb, or absorb corrosive gases;
the second protective layer (6) covers at least a top surface of the first protective layer (5), wherein a top surface of the first protective layer (5) is a surface facing away from the dielectric substrate (10),
the second protective layer (6) further comprises vertical sections covering side surfaces of the first protective layer (5) and arranged between the first protective layer (5) and the sidewalls of the housing (7), and
the seal (8) comprises a third material and a fourth material (62), wherein the fourth material (62) is distributed within the third material and comprises a reactant, wherein the reactant is configured to chemically react with, trap, adsorb, or absorb corrosive gases.

11. Method for producing a power semiconductor module arrangement (100), the method comprising:
arranging a seal (8) between sidewalls of a housing (7) and a bottom of the housing (7), or between the sidewalls of the housing (7) and a base plate (50), thereby attaching the sidewalls to the bottom or to the base plate (50);
arranging a dielectric substrate (10) on the bottom of the housing (7) or on the base plate (50);
forming a first protective layer (5) on a top surface of the dielectric substrate (10), thereby covering at least one semiconductor body (20) arranged on the top surface of the dielectric substrate (10);
forming a second protective layer (6) on the first protective layer (5) for protecting the power semiconductor module arrangement (100), wherein
the second protective layer (6) comprises a first material and a second material (61), wherein the second material (61) is distributed within the first material and comprises a reactant, wherein the reactant is configured to chemically react with, trap, adsorb, or absorb corrosive gases;
the second protective layer (6) covers at least a top surface of the first protective layer (5), wherein a top surface of the first protective layer (5) is a surface facing away from the dielectric substrate (10),
the second protective layer (6) further comprises vertical sections covering side surfaces of the first protective layer (5) and arranged between the first protective layer (5) and the sidewalls of the housing (7), and
the seal (8) comprises a third material and a fourth material (62), wherein the fourth material (62) is distributed within the third material and comprises a reactant, wherein the reactant is configured to chemically react with, trap, adsorb, or absorb corrosive gases.

## Patentansprüche

1. Leistungshalbleitermodulanordnung (100), umfassend:
ein dielektrisches Substrat (10), ein Gehäuse (7), das Seitenwände umfasst;
mindestens einen Halbleiterbody (20), der auf einer Oberseite des Substrats (10) angeordnet ist;
eine erste Schutzschicht (5), die auf der Oberseite des dielektrischen Substrats (10) angeordnet ist, wodurch der mindestens eine Halbleiterbody (20) bedeckt wird;
eine zweite Schutzschicht (6) zum Schützen der Leistungshalbleitermodulanordnung (100); und
eine Dichtung (8), wobei
die zweite Schutzschicht (6) ein erstes Material und ein zweites Material (61) umfasst, wobei das zweite Material (61) innerhalb des ersten Materials verteilt ist und einen Reaktanten umfasst, wobei der Reaktant dazu ausgelegt ist, korrosive Gase einzufangen, zu adsorbieren, zu absorbieren oder chemisch damit zu reagieren;
die zweite Schutzschicht (6) mindestens eine Oberseite der ersten Schutzschicht (5) bedeckt, wobei eine Oberseite der ersten Schutzschicht (5) eine Oberfläche ist, die von dem dielektrischen Substrat (10) weg weist, die zweite Schutzschicht (6) ferner vertikale Abschnitte umfasst, die Seitenflächen der ersten Schutzschicht (5) bedecken und zwischen der ersten Schutzschicht (5) und den Seitenwänden des Gehäuses (7) angeordnet sind, und
die Dichtung (8) zwischen den Seitenwänden des Gehäuses (7) und dem dielektrischen Substrat (10) angeordnet ist, wodurch das Gehäuse (7) an dem dielektrischen Substrat (10) befestigt wird, wobei das dielektrische Substrat einen Boden des Gehäuses bildet, und die Dichtung ein drittes Material und ein viertes Material (62) umfasst, wobei das vierte Material (62) innerhalb des dritten Materials verteilt ist und einen Reaktanten umfasst, wobei der Reaktant dazu ausgelegt ist, korrosive Gase einzufangen, zu adsorbieren, zu absorbieren oder chemisch damit zu reagieren.

2. Leistungshalbleitermodulanordnung (100) nach Anspruch 1, wobei jedes von dem ersten Material und dem dritten Material mindestens eines von Folgenden umfasst:
ein nicht reaktives Polymer;
ein Gussmaterial; und
ein Epoxidharz.

3. Leistungshalbleitermodulanordnung (100) nach Anspruch 2, wobei das nicht reaktive Polymer Silikongel oder Silikonkautschuk umfasst.

4. Leistungshalbleitermodulanordnung (100) nach einem der Ansprüche 1 bis 3, wobei jedes von dem zweiten Material (61) und dem vierten Material (62) eines von einem metallischen Material und einer Aktivkohle umfasst.

5. Leistungshalbleitermodulanordnung (100) nach Anspruch 4, wobei das metallische Material mindestens eines von Ag, Fe, Co, Ni, Cu, Sn, Pb und Mn umfasst.

6. Leistungshalbleitermodulanordnung (100) nach einem der vorhergehenden Ansprüche, wobei die zweite Schutzschicht (6) eine Dicke in einer vertikalen Richtung (y) von 0,3 mm bis 10 mm aufweist.

7. Leistungshalbleitermodulanordnung (100) nach einem der Ansprüche 1 bis 6, wobei jeder der vertikalen Abschnitte der zweiten Schutzschicht (6) eine Dicke in einer horizontalen Richtung (x) von 0,3 mm bis 10 mm aufweist.

8. Leistungshalbleitermodulanordnung (100) nach einem der vorhergehenden Ansprüche,
wobei das Innere des Gehäuses (7) einen ersten Bereich und einen zweiten Bereich umfasst; und
wobei die zweite Schutzschicht (6) zwischen dem ersten Bereich und dem zweiten Bereich angeordnet ist, um den mindestens einen Halbleiterbody (20) vor korrosiven Gasen zu schützen, die in dem ersten Bereich angeordnet sind.

9. Leistungshalbleitermodulanordnung (100), umfassend:
ein dielektrisches Substrat (10), das innerhalb eines Gehäuses (7) angeordnet ist, wobei das Gehäuse (7) Seitenwände umfasst;
mindestens einen Halbleiterbody (20), der auf einer Oberseite des Substrats (10) angeordnet ist;
eine erste Schutzschicht (5), die auf der Oberseite des dielektrischen Substrats (10) angeordnet ist, wodurch der mindestens eine Halbleiterbody (20) bedeckt wird;
eine zweite Schutzschicht (6) zum Schützen der Leistungshalbleitermodulanordnung (100); und
eine Dichtung (8), wobei
die zweite Schutzschicht (6) ein erstes Material und ein zweites Material (61) umfasst, wobei das zweite Material (61) innerhalb des ersten Materials verteilt ist und einen Reaktanten umfasst, wobei der Reaktant dazu ausgelegt ist, korrosive Gase einzufangen, zu adsorbieren, zu absorbieren oder chemisch damit zu reagieren;
die zweite Schutzschicht (6) mindestens eine Oberseite der ersten Schutzschicht (5) bedeckt, wobei eine Oberseite der ersten Schutzschicht (5) eine Oberfläche ist, die von dem dielektrischen Substrat (10) weg weist, die zweite Schutzschicht (6) ferner vertikale Abschnitte umfasst, die Seitenflächen der ersten Schutzschicht (5) bedecken und zwischen der ersten Schutzschicht (5) und den Seitenwänden des Gehäuses (7) angeordnet sind, und
die Dichtung (8) entweder zwischen den Seitenwänden des Gehäuses (7) und einem Boden des Gehäuses (7) oder zwischen den Seitenwänden des Gehäuses (7) und einer Basisplatte (50) angeordnet ist, wodurch das Gehäuse (7) an dem Boden des Gehäuses oder an der Basisplatte (50) befestigt wird, und die Dichtung ein drittes Material und ein viertes Material (62) umfasst, wobei das vierte Material (62) innerhalb des dritten Materials verteilt ist und einen Reaktanten umfasst, wobei der Reaktant dazu ausgelegt ist, korrosive Gase einzufangen, zu adsorbieren, zu absorbieren oder chemisch damit zu reagieren.

10. Verfahren zur Herstellung einer Leistungshalbeitermodulanordnung (100), wobei das Verfahren Folgendes umfasst:
Anordnen einer Dichtung (8) zwischen Seitenwänden eines Gehäuses (7) und einem dielektrischen Substrat (10), wodurch das Gehäuse (7) an dem dielektrischen Substrat (10) befestigt wird;
Bilden einer ersten Schutzschicht (5) auf einer Oberseite des dielektrischen Substrats (10), wodurch mindestens ein Halbleiterbody (20) bedeckt wird, der auf der Oberseite des dielektrischen Substrats (10) angeordnet ist;
Bilden einer zweiten Schutzschicht (6) auf der ersten Schutzschicht (5) zum Schützen der Leistungshalbleitermodulanordnung (100), wobei
die zweite Schutzschicht (6) ein erstes Material und ein zweites Material (61) umfasst, wobei das zweite Material (61) innerhalb des ersten Materials verteilt ist und einen Reaktanten umfasst, wobei der Reaktant dazu ausgelegt ist, korrosive Gase einzufangen, zu adsorbieren, zu absorbieren oder chemisch damit zu reagieren;
die zweite Schutzschicht (6) mindestens eine Oberseite der ersten Schutzschicht (5) bedeckt, wobei eine Oberseite der ersten Schutzschicht (5) eine Oberfläche ist, die von dem dielektrischen Substrat (10) weg weist, die zweite Schutzschicht (6) ferner vertikale Abschnitte umfasst, die Seitenflächen der ersten Schutzschicht (5) bedecken und zwischen der ersten Schutzschicht (5) und den Seitenwänden des Gehäuses (7) angeordnet sind, und
die Dichtung (8) ein drittes Material und ein viertes Material (62) umfasst, wobei das vierte Material (62) innerhalb des dritten Materials verteilt ist und einen Reaktanten umfasst, wobei der Reaktant dazu ausgelegt ist, korrosive Gase einzufangen, zu adsorbieren, zu absorbieren oder chemisch damit zu reagieren.

11. Verfahren zur Herstellung einer Leistungshalbeitermodulanordnung (100), wobei das Verfahren Folgendes umfasst:
Anordnen einer Dichtung (8) zwischen Seitenwänden eines Gehäuses (7) und einem Boden des Gehäuses (7) oder zwischen den Seitenwänden des Gehäuses (7) und einer Basisplatte (50), wodurch die Seitenwände an dem Boden oder an der Basisplatte (50) befestigt werden;
Anordnen eines dielektrischen Substrats (10) auf dem Boden des Gehäuses (7) oder auf der Basisplatte (50);
Bilden einer ersten Schutzschicht (5) auf einer Oberseite des dielektrischen Substrats (10), wodurch mindestens ein Halbleiterbody (20) bedeckt wird, der auf der Oberseite des dielektrischen Substrats (10) angeordnet ist;
Bilden einer zweiten Schutzschicht (6) auf der ersten Schutzschicht (5) zum Schützen der Leistungshalbleitermodulanordnung (100), wobei
die zweite Schutzschicht (6) ein erstes Material und ein zweites Material (61) umfasst, wobei das zweite Material (61) innerhalb des ersten Materials verteilt ist und einen Reaktanten umfasst, wobei der Reaktant dazu ausgelegt ist, korrosive Gase einzufangen, zu adsorbieren, zu absorbieren oder chemisch damit zu reagieren;
die zweite Schutzschicht (6) mindestens eine Oberseite der ersten Schutzschicht (5) bedeckt, wobei eine Oberseite der ersten Schutzschicht (5) eine Oberfläche ist, die von dem dielektrischen Substrat (10) weg weist, die zweite Schutzschicht (6) ferner vertikale Abschnitte umfasst, die Seitenflächen der ersten Schutzschicht (5) bedecken und zwischen der ersten Schutzschicht (5) und den Seitenwänden des Gehäuses (7) angeordnet sind, und
die Dichtung (8) ein drittes Material und ein viertes Material (62) umfasst, wobei das vierte Material (62) innerhalb des dritten Materials verteilt ist und einen Reaktanten umfasst, wobei der Reaktant dazu ausgelegt ist, korrosive Gase einzufangen, zu adsorbieren, zu absorbieren oder chemisch damit zu reagieren.

## Revendications

1. Un agencement (100) de module de semiconducteur de puissance comprenant :
un substrat (10) diélectrique, un boîtier (7) ayant des parois latérales ;
au moins un corps (20) à semiconducteur disposé sur une surface de sommet du substrat (10) diélectrique ;
une première couche (5) de protection disposée sur la surface de sommet du substrat (10) diélectrique, en recouvrant ainsi le au moins un corps (20) à semiconducteur ;
une deuxième couche (6) de protection pour protéger l'agencement (100) de module de semiconducteur de puissance ; et
un joint (8), dans lequel
la deuxième couche (6) de protection comprend un premier matériau et un deuxième matériau (61),
dans lequel le deuxième matériau (61) est réparti dans le premier matériau et comprend un réactif, dans lequel le réactif est configuré pour réagir chimiquement sur, piéger, adsorber ou absorber des gaz corrosifs ;
la deuxième couche (6) de protection recouvre au moins une surface de sommet de la première couche (5) de protection, dans lequel une surface de sommet de la première couche (5) de protection est une surface en face du substrat (10) diélectrique en en étant loin,
la deuxième couche (6) de protection comprend en outre des parties recouvrant des surfaces latérales de la première couche (5) de protection et interposées entre la première couche (5) de protection et les parois latérales du boîtier (7), et
le joint (8) est interposé entre les parois latérales du boîtier (7) et le substrat (10) diélectrique en fixant ainsi le boîtier (7) au substrat (10) diélectrique, dans lequel le substrat diélectrique forme un fond du boîtier, et le joint comprend un troisième matériau et un quatrième matériau (62), dans lequel le quatrième matériau (62) est réparti dans le troisième matériau et comprend un réactif, dans lequel le réactif est configuré pour réagir chimiquement sur, piéger, adsorber ou absorber des gaz corrosifs.

2. L'agencement (100) de module de semiconducteur de puissance de la revendication 1, dans lequel chacun du premier matériau et du troisième matériau comprend au moins l'un de
un polymère non réactif ;
un matériau de coulée ; et
une résine époxy.

3. L'agencement (100) de module de semiconducteur de puissance de la revendication 2, dans lequel le polymère non réactif comprend du gel de silicone ou du caoutchouc de silicone.

4. L'agencement (100) de module de semiconducteur de puissance de l'une quelconque des revendications 1 à 3, dans lequel chacun du deuxième matériau (61) et du quatrième matériau (62) comprend l'un d'un matériau métallique et d'un charbon actif.

5. L'agencement (100) de module de semiconducteur de puissance de la revendication 4, dans lequel le matériau métallique comprend au moins l'un de Ag, Fe, Co, Ni, Cu, Sn, Pb, et Mn.

6. L'agencement (100) de module de semiconducteur de puissance de l'une quelconque des revendications précédentes, dans lequel la deuxième couche (6) de protection a une épaisseur dans une direction (y) verticale comprise entre 0,3 mm et 10 mm.

7. L'agencement (100) de module de semiconducteur de puissance de l'une quelconque des revendications 1 à 6, dans lequel chacune des parties verticales de la deuxième couche (6) de protection a une épaisseur dans une direction (x) horizontale comprise entre 0,3 mm et 10 mm.

8. L'agencement (100) de module de semiconducteur de puissance de l'une quelconque des revendications précédentes,
dans lequel l'intérieur du boîtier (7) comprend une première zone et une deuxième zone ; et
dans lequel la deuxième couche (6) de protection est interposée entre la première zone et la deuxième zone afin de protéger le au moins un corps (20) à semiconducteur des gaz corrosifs, qui sont disposés dans la première zone.

9. Un agencement (100) de module de semiconducteur de puissance comprenant :
un substrat (10) diélectrique disposé dans le boîtier (7), un boîtier (7) ayant des parois latérales ;
au moins un corps (20) à semiconducteur disposé sur une surface de sommet du substrat (10) diélectrique ;
une première couche (5) de protection disposée sur la surface de sommet du substrat (10) diélectrique, en recouvrant ainsi le au moins un corps (20) à semiconducteur ;
une deuxième couche (6) de protection pour protéger l'agencement (100) de module de semiconducteur de puissance ; et
un joint (8), dans lequel
la deuxième couche (6) de protection comprend un premier matériau et un deuxième matériau (61), dans lequel le deuxième matériau (61) est réparti dans le premier matériau et comprend un réactif, dans lequel le réactif est configuré pour réagir chimiquement sur, piéger, adsorber ou absorber des gaz corrosifs ;
la deuxième couche (6) de protection recouvre au moins une surface de sommet de la première couche (5) de protection, dans lequel une surface de sommet de la première couche (5) de protection est une surface en face du substrat (10) diélectrique en en étant loin,
la deuxième couche (6) de protection comprend en outre des parties recouvrant des surfaces latérales de la première couche (5) de protection et interposées entre la première couche (5) de protection et les parois latérales du boîtier (7), et
le joint (8) est interposé entre les parois latérales du boîtier (7) et un fond du boîtier (7), ou entre les parois latérales du boîtier (7) et une plaque (50) de base, en fixant ainsi le boîtier (7) au fond du boîtier ou à la plaque (50) de base, et le joint comprend un troisième matériau et un quatrième matériau (62), dans lequel le quatrième matériau (62) réparti dans le troisième matériau et comprend un réactif, dans lequel le réactif est configuré pour réagir chimiquement sur, piéger, adsorber ou absorber des gaz corrosifs.

10. Procédé de production d'un agencement (100) de module de semiconducteur de puissance, le procédé comprenant :
mettre un joint (8) entre les parois latérales d'un boîtier (7) et un substrat (10) diélectrique en fixant ainsi le boîtier (7) au substrat (10) diélectrique ;
former une première couche (5) de protection sur une surface de sommet du substrat (10) diélectrique,
en recouvrant ainsi au moins un corps (20) à semiconducteur disposé sur la surface de sommet du substrat (10) diélectrique ;
former une deuxième couche (6) de protection sur la première couche (5) de protection pour protéger l'agencement (100) de module de semiconducteur de puissance, dans lequel
la deuxième couche (6) de protection comprend un premier matériau et un deuxième matériau (61),
dans lequel le deuxième matériau (61) réparti dans le premier matériau et comprend un réactif, dans lequel le réactif est configuré pour réagir chimiquement sur, piéger, adsorber ou absorber des gaz corrosifs ;
la deuxième couche (6) de protection recouvre au moins une surface de sommet de la première couche (5) de protection, dans lequel une surface de sommet de la première couche (5) de protection est une surface faisant face au substrat (10) diélectrique en en étant loin,
la deuxième couche (6) de protection comprend en outre des parties verticales recouvrant des surfaces latérales de la première couche (5) de protection et interposées entre la première couche (5) de protection et les parois latérales du boîtier (7), et
le joint (8) comprend un troisième matériau et un quatrième matériau (62), dans lequel le quatrième matériau (62) est réparti dans le troisième matériau et comprend un réactif, dans lequel le réactif est configuré pour réagir chimiquement sur, piéger, adsorber ou absorber des gaz corrosifs.

11. Procédé de production d'un agencement (100) de module de semiconducteur de puissance, le procédé comprenant :
mettre un joint (8) entre les parois latérales d'un boîtier (7) et un fond du boîtier (7) ou entre les parois latérales du boîtier (7) et une plaque (50) de base, en fixant ainsi les parois latérales au fond ou à la plaque (50) de base ;
mettre un substrat (10) diélectrique sur le fond du boîtier (7) ou sur la plaque (50) de base ;
former une première couche (5) de protection sur une surface de sommet du substrat (10) diélectrique,
en recouvrant ainsi au moins un corps (20) à semiconducteur disposé sur la surface de sommet du substrat (10) diélectrique ;
former une deuxième couche (6) de protection sur la première couche (5) de protection pour protéger l'agencement (100) de module de semiconducteur de puissance, dans lequel
la deuxième couche (6) de protection comprend un premier matériau et un deuxième matériau (61),
dans lequel le deuxième matériau (61) est réparti dans le premier matériau et comprend un réactif, dans lequel le réactif est configuré pour réagir chimiquement sur, piéger, adsorber ou absorber des gaz corrosifs ;
la deuxième couche (6) de protection recouvre au moins une surface de sommet de la première couche (5) de protection, dans lequel une surface de sommet de la première couche (5) de protection est une surface faisant face au substrat (10) diélectrique en en étant loin,
la deuxième couche (6) de protection comprend en outre des parties verticales recouvrant des surfaces latérales de la première couche (5) de protection et interposées entre la première couche (5) de protection et les parois latérales du boîtier (7), et
le joint (8) comprend un troisième matériau et un quatrième matériau (62), dans lequel le quatrième matériau (62) est réparti dans le troisième matériau et comprend un réactif, dans lequel le réactif est configuré pour réagir chimiquement sur, piéger, adsorber ou absorber des gaz corrosifs.
